# EUROPEAN PATENT APPLICATION

(11) **EP 4 783 235 A1**
(43) Date of publication of application: **29.07.2026**
(21) Application number: 24868237.9
(22) Date of filing: 17.09.2024
(51) Int. Cl.: H01L 23/04

(54) **WIRING STRUCTURE AND ELECTRONIC MODULE**

(30) Priority: 19.09.2023 JP 2023151521
(71) Applicant: Kyocera Corporation, Kyoto-shi, Kyoto 612-8501 (JP)
(72) Inventor: KAWAZU, Yoshiki, Kyoto-shi, Kyoto 612-8501 (JP); MATSUMOTO, Toshiyuki, Kyoto-shi, Kyoto 612-8501 (JP)
(74) Representative: Viering, Jentschura & Partner mbB Patent- und Rechtsanwälte
(86) International application number: PCT/JP2024/033061
(87) International publication number: WO 2025/063160

(57) **Abstract**

A wiring structural body includes a first wiring board, a second wiring board, and a first connector connecting the first wiring board and the second wiring board. The first wiring board includes a first member, a second member, and a first conductor portion. The second wiring board includes a first insulating layer and a second conductor portion. The first insulating layer includes a first surface and a second surface. The first member includes a first upper surface and a first side surface. The second member includes a second upper surface. The first conductor portion includes a first conductor positioned on the first upper surface, and a second conductor positioned on the second upper surface. The second conductor portion includes a first connection conductor positioned on the second surface, and a second connection conductor positioned on the first surface. At least part of the second surface faces the first upper surface and is positioned to be overlapped with the first upper surface in plan view. The first conductor and the first connection conductor are bonded to each other, and the first connector electrically connects the second conductor and the second connection conductor.

## Description

### TECHNICAL FIELD

The present disclosure relates to a wiring structural body and an electronic module.

### BACKGROUND OF INVENTION

Patent Literature 1 and the like describe a conventional wiring structural body.

### CITATION LIST

### PATENT LITERATURE

Patent Literature 1: Japanese Unexamined Patent Application Publication No. 2007-5636

### SUMMARY

### SOLUTION TO PROBLEM

According to an embodiment of the present disclosure, (1) a wiring structural body includes a first wiring board, a second wiring board, and a first connector electrically connecting the first wiring board and the second wiring board. The first wiring board includes a first member, a second member provided continuously to the first member, and a first conductor portion. The second wiring board includes a first insulating layer and a second conductor portion. The second wiring board extends from the second member. The first insulating layer includes a first surface and a second surface provided opposite to the first surface. The first member includes a first upper surface and a first side surface crossing the first upper surface. The second member includes a second upper surface, and faces or is positioned on a surface different from the first side surface of the first member. The first conductor portion includes a first conductor positioned on the first upper surface, and a second conductor positioned on the second upper surface. The second conductor portion includes a first connection conductor positioned on the second surface, and a second connection conductor positioned on the first surface. At least part of the second surface faces the first upper surface and is positioned to be overlapped with the first upper surface in plan view. The first conductor and the first connection conductor are bonded to each other. The first connector electrically connects the second conductor and the second connection conductor.

(2) In the wiring structural body according to (1) described above, the first conductor and the first connection conductor are ground conductors.

(3) In the wiring structural body according to (1) or (2) described above, the second conductor and the second connection conductor are signal conductors or ground conductors.

(4) According to (1) or (2) described above, the wiring structural body further includes a second connector electrically connecting the first wiring board and the second wiring board. The first conductor portion further includes a third conductor positioned to be spaced apart from the second conductor on the second upper surface. The second conductor portion further includes a third connection conductor positioned to be spaced apart from the second connection conductor on the first surface. The second connector electrically connects the third conductor and the third connection conductor. The first conductor and the first connection conductor are ground conductors. The second conductor and the second connection conductor are ground conductors. The third conductor and the third connection conductor are signal conductors.

(5) In the wiring structural body according to (1) to (4) described above, the first connection conductor and the second connection conductor are electrically connected to each other in the second wiring board.

(6) In the wiring structural body according to (1) to (5) described above, the second member includes a second side surface crossing the first upper surface and the second upper surface. Furthermore, the first upper surface is positioned lower than the second upper surface.

(7) In the wiring structural body according to (6) described above, in sectional view perpendicular to the first upper surface, a distance L1 from the first upper surface to the second upper surface is equal to or more than a distance L2 from the first upper surface to the first surface.

(8) In the wiring structural body according to (6) or (7) described above, the second wiring board is in contact with the second side surface.

(9) In the wiring structural body according to (1) to (8) described above, the second member includes a second side surface crossing the first upper surface and the second upper surface. The second side surface includes a first cutout, and a first conductor layer provided in the first cutout. The second wiring board includes a surface facing the second side surface and including a second cutout and a second conductor layer provided in the second cutout. The first conductor layer and the second conductor layer are bonded to each other by a bonding material.

(10) In the wiring structural body according to (1) to (9) described above, the second member includes a second side surface crossing the first upper surface and the second upper surface. The first upper surface is positioned lower than the second upper surface. The first conductor portion includes a side surface conductor connecting the first conductor and the second conductor. The side surface conductor is positioned on the second side surface.

(11) In the wiring structural body according to (1) to (10) described above, the first connector is a wire.

(12) In the wiring structural body according to (11) described above, the first connector is covered with an insulating material.

(13) In the wiring structural body according to (1) to (12) described above, the second wiring board is a flexible wiring board.

(14) According to (1) to (13) described above, the wiring structural body further includes a third wiring board electrically connected to the second wiring board.

(15) According to (1) to (14) described above, the wiring structural body further includes a box accommodating an electronic component. The first wiring board is part of the box. The first member and the second member are at least partially exposed from the box.

In an embodiment, (16) an electronic module includes the wiring structural body according to (1) to (14) described above, and an electronic component electrically connected to the first conductor portion.

In an embodiment, (17) an electronic module includes the wiring structural body according to (15) described above, an electronic component accommodated in the box, and a lid positioned on the box.

### BRIEF DESCRIPTION OF THE DRAWINGS

FIG. 1 is a perspective view of a wiring structural body and an electronic module according to an embodiment.
FIG. 2 is a perspective view of a first wiring board of a wiring structural body according to an embodiment.
FIG. 3 is a perspective view from below of a wiring structural body according to an embodiment.
FIG. 4 is an enlarged view of a principal part IV of the wiring structural body illustrated in FIG. 1.
FIG. 5 is a sectional view taken along line V-V of the wiring structural body illustrated in FIG. 4.
FIG. 6 is a sectional view taken along line VI-VI of the wiring structural body illustrated in FIG. 4.
FIG. 7 is a sectional view of an exemplary wiring structural body including a fourth wiring board.
FIG. 8 is a perspective view of an exemplary wiring structural body including the fourth wiring board.
FIG. 9 is a sectional view of an exemplary wiring structural body including the fourth wiring board.
FIG. 10 is an enlarged view of a first cutout, a first conductor layer, a second cutout, and a second conductor layer.
FIG. 11 is a graph indicating reflection characteristics of a wiring structural body according to an embodiment and reflection characteristics of a wiring structural body according to a comparative example.
FIG. 12 is a graph indicating pass characteristics of a wiring structural body according to an embodiment and pass characteristics of a wiring structural body according to the comparative example.

### DESCRIPTION OF EMBODIMENTS

### <Configuration of wiring structural body>

Several exemplary embodiments will be described hereinafter with reference to the drawings. A wiring structural body may be disposed to include a top or a bottom in any direction. For convenience, the wiring structural body is defined to have an orthogonal coordinate system xyz, and a positive side in a z direction is assumed to indicate an upper side. In the present disclosure, a plan view conceptually includes a plan perspective view.

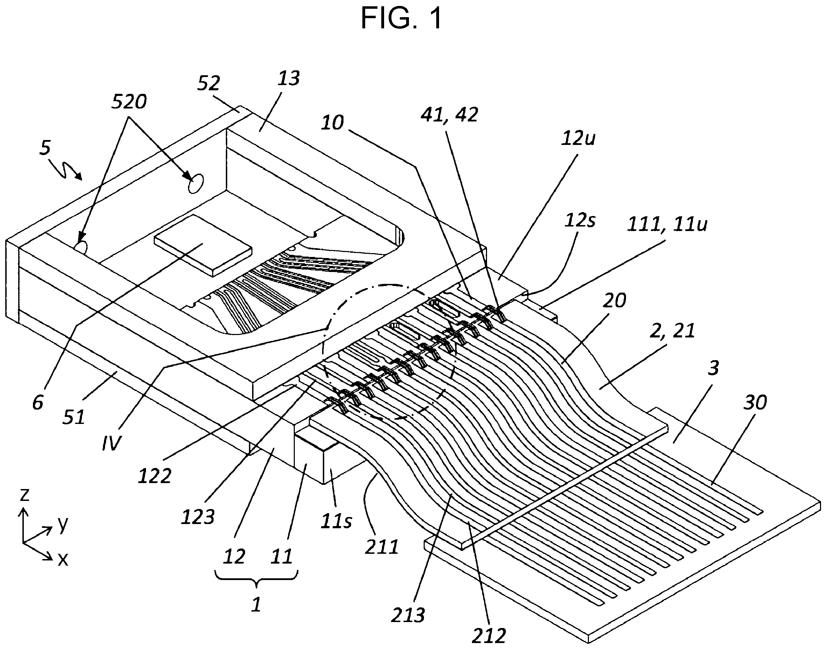

As illustrated in FIGs. 1 to 6, the wiring structural body includes a first wiring board 1, a second wiring board 2, and a first connector 41 electrically connecting the first wiring board 1 and the second wiring board 2.

The first wiring board 1 includes a first member 11, a second member 12 provided continuously to the first member 11, and a first conductor portion 10.

The first member 11 includes a first upper surface 11u, and a first side surface 11s crossing the first upper surface 11u. The first member 11 may include a first lower surface 11b provided opposite to the first upper surface 11u. The first member 11 may be made of an insulating material, examples of which include a ceramic material such as an aluminum oxide sintered body, a mullite sintered body, a silicon carbide sintered body, an aluminum nitride sintered body, a silicon nitride sintered body, or a glass ceramic.

The first member 11 may alternatively be made of a resin material. Examples of the resin material can include any one selected from epoxy resin, phenolic resin, unsaturated polyester resin, polytetrafluoroethylene resin, urea resin, melamine resin, thermosetting polyimide resin, and the like. The first member 11 may alternatively be made of a metallic material. Examples of the metallic material include metallic materials such as copper, iron, tungsten, molybdenum, nickel, and cobalt, and an alloy containing any of these metallic materials.

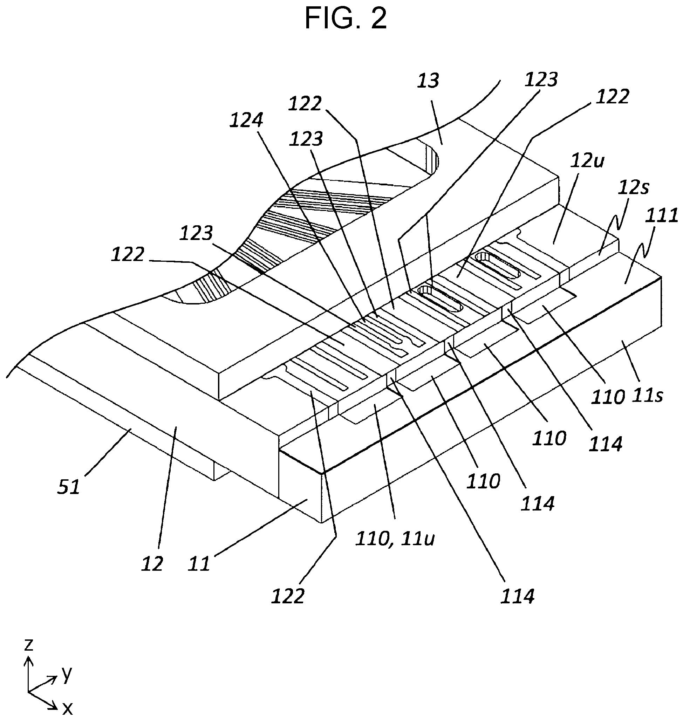

The second member 12 includes a second upper surface 12u, and faces or is positioned on a surface different from the first side surface 11s of the first member 11. According to the embodiment illustrated in FIG. 2, the second member 12 is positioned opposite to the first side surface 11s of the first member 11 in an x direction. According to a variation, the second member 12 may exemplarily face or be positioned on a side surface in a y direction of the first member 11. The second member 12 may include a second lower surface 12b provided opposite to the second upper surface 12u. The second member 12 may be made of a material identical to or different from the material for the first member 11. When the first member 11 and the second member 12 are made of an identical material, the first member 11 may be formed integrally with the second member 12. Particularly when the second member 12 is made of a ceramic material, wiring can be positioned easily in the second member 12.

When the first member 11 and the second member 12 are made of different materials, the first member 11 and the second member 12 may be bonded to each other by a conductive adhesive (e.g., silver epoxy resin). In this case, wiring provided in the second member 12 and a first conductor 111 (to be described later) provided on the first member 11 may be electrically connected to each other by a conductive adhesive. The first member 11 and the second member 12 do not need to be in contact with each other without any gap in this case, and may partially interpose a space therebetween.

Wiring may be positioned in an inner layer of the first member 11 and/or the second member 12.

The first conductor portion 10 includes the first conductor 111 positioned on the first upper surface 11u of the first member 11, and a second conductor 122 positioned on the second upper surface 12u of the second member 12. The first conductor portion 10 is made of a material, examples of which include metallic materials such as gold, silver, copper, nickel, tungsten, molybdenum, and manganese. The first conductor portion 10 may be formed by sintering a metal paste on the first member 11 and/or the second member 12, or may be formed in accordance with a thin film forming technique such as an evaporation method or a sputtering method. The first conductor portion 10 may be provided on its surface with a plating layer. When the first member 11 is made of a metallic material, the first conductor 111 to be described later may be formed only by plating.

As illustrated in FIG. 2, in an embodiment, the first conductor 111 is positioned to entirely cover the first upper surface 11u, but is not necessarily positioned in this manner. For example, the first conductor 111 may be provided partially discontinuously, or a plurality of first conductors 111 may be provided. FIG. 2 assumes that the first conductor 111 is a ground conductor. Alternatively, the first upper surface 11u may be provided with a plurality of first conductors 111 as signal conductors and/or ground conductors, and the first conductors 111 may be shaped identically with the second conductor 122 and/or a third conductor 123 positioned on the second upper surface 12u.

The second wiring board 2 includes a first insulating layer 21 and a second conductor portion 20. The second wiring board 2 extends from the second member 12. The second wiring board 2 may have flexibility, and may be exemplarily a so-called flexible wiring board (FPC (flexible printed circuit)) or a printed substrate (PCB (printed circuit board)) provided with an electronic circuit. When the second wiring board 2 is a flexible wiring board, the second wiring board 2 can be arranged easily and is improved in design flexibility. When the second wiring board 2 is a flexible wiring board, the first insulating layer 21 is made of a resin material.

The second wiring board 2 may be further bonded to the first side surface 11s by an insulating adhesive. This can reduce a possibility that the second wiring board 2 is displaced with respect to the first wiring board 1 or falls off.

The second conductor portion 20 of the second wiring board 2 may be partially provided thereon with an insulating film. More specifically, the insulating film may be positioned on the second conductor portion 20 in a region other than a portion where the second wiring board 2 and the first wiring board 1 are overlapped with each other in plan view and/or a portion where the second wiring board 2 and a third wiring board 3 to be described later are overlapped with each other in plan view. This configuration can reduce a possibility of damage or corrosion of the second conductor portion 20. Examples of the insulating film include a cover lay.

The first insulating layer 21 of the second wiring board 2 includes a first surface 21u and a second surface 21b provided opposite to the first surface 21u. At least part of the second surface 21b faces the first upper surface 11u of the first wiring board 1, and is positioned to be overlapped with the first upper surface 11u in plan view. In other words, the second wiring board 2 is at least partially overlapped with the first wiring board 1. The first insulating layer 21 may be exemplarily made of a resin. The first insulating layer 21 may be lower in dielectric constant than the first member 11 and/or the second member 12.

As illustrated in FIGs. 1, 3, 4, 5, and 6, the second conductor portion 20 of the second wiring board 2 includes a first connection conductor 211 positioned on the second surface 21b, and a second connection conductor 212 positioned on the first surface 21u. The second conductor portion 20 is made of a material, examples of which include a metallic material. The second conductor portion 20 may be in contact with or distant from an end surface of the first insulating layer 21.

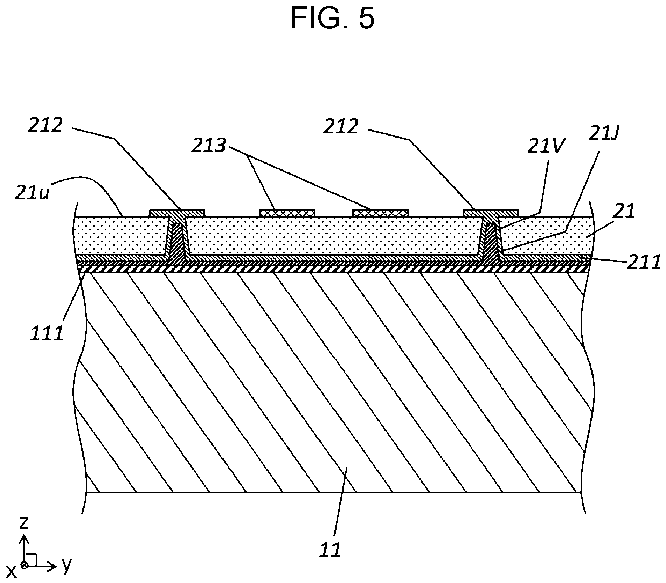

As illustrated in FIG. 5, the first conductor 111 of the first wiring board 1 and the first connection conductor 211 of the second wiring board 2 are bonded to each other. The first conductor 111 and the first connection conductor 211 may be bonded by a bonding material 21J such as solder or a conductive resin.

The first connector 41 electrically connects the second conductor 122 of the first wiring board 1 and the second connection conductor 212 of the second wiring board 2. The above configuration enables fine designing of the first conductor portion 10 and the second conductor portion 20 in the wiring structural body in comparison to a case where the first wiring board 1 and the second wiring board 2 are electrically connected to each other without use of the first connector 41. This allows increases in the numbers of the first conductor portions 10 and the second conductor portions 20 as electrodes, and achieves higher density and higher integration of wiring. When the second conductor 122 and the second connection conductor 212 are utilized as signal conductors, the wiring structural body can be adapted to transmission of radio-frequency signals.

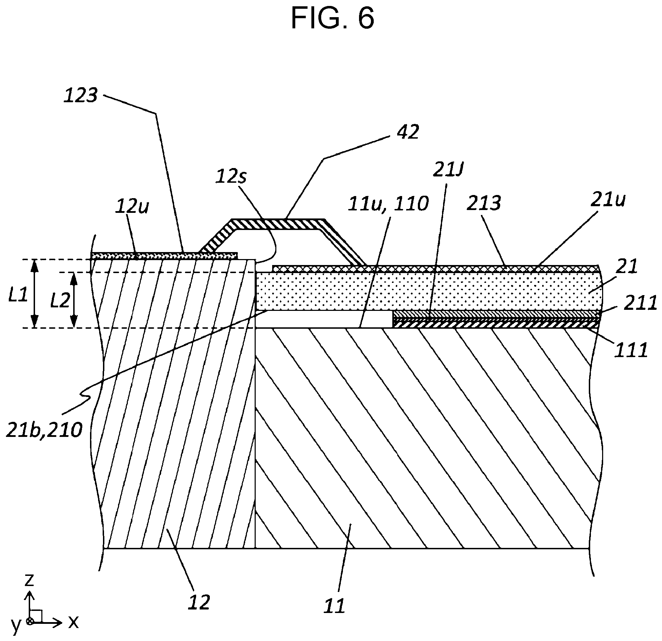

As illustrated in FIGs. 5 and 6, in an embodiment, the first conductor 111 and the first connection conductor 211 may be ground conductors. This configuration achieves an increase in the area of the ground conductors and can enhance ground potential.

The second conductor 122 and the second connection conductor 212 may be signal conductors or ground conductors. When the first conductor 111 and the first connection conductor 211 are ground conductors, the second conductor 122 and the second connection conductor 212 may be signal conductors. In this configuration, the first conductor portion 10 and the second conductor portion 20 can each have a coplanar structure, and signal transmission can be stabilized in the second conductor 122 and the second connection conductor 212. In the embodiment illustrated in FIGs. 1 to 6, the second conductor 122 and the second connection conductor 212 are ground conductors.

The first connection conductor 211 of the second wiring board 2 may cover 70% or more of an area of the second surface 21b. This configuration achieves an increase in an area of the first connection conductor 211 as a ground conductor and can enhance ground potential on the second wiring board 2.

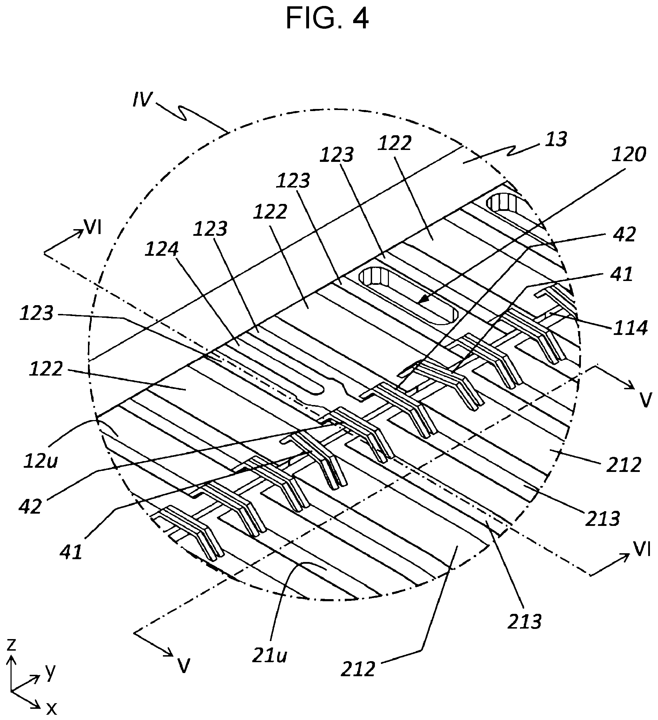

As illustrated in FIG. 4, in an embodiment, the wiring structural body may further include a second connector 42 electrically connecting the first wiring board 1 and the second wiring board 2. The first conductor portion 10 may further include the third conductor 123 positioned to be spaced apart from the second conductor 122 on the second upper surface 12u of the second member 12. The second conductor portion 20 may further include a third connection conductor 213 positioned to be spaced apart from the second connection conductor 212 on the first surface 21u. The second connector 42 electrically connects the third conductor 123 and the third connection conductor 213. The first conductor 111 and the first connection conductor 211 may be ground conductors, the second conductor 122 and the second connection conductor 212 may be ground conductors, and the third conductor 123 and the third connection conductor 213 may be signal conductors. The first conductor portion 10 can be designed finely as described above, so that the third conductor 123 and the third connection conductor 213 can be reduced in size particularly in the y direction. The above configuration can thus facilitate impedance adjustment in the third conductor 123 and the third connection conductor 213. The wiring structural body can therefore be adapted to transmission of radio-frequency signals. This also allows increases in the numbers of the third conductor 123 and the third connection conductor 213, and the wiring structural body can be provided with a larger number of signal channels.

As illustrated in FIGs. 2 and 4, the size in the y direction of the third conductor 123 may be gradually increased toward a second side surface 12s. That is, the third conductor 123 may be gradually increased in width toward the second side surface 12s. This configuration achieves stable bonding of the second connector 42. This configuration also allows connection of a plurality of second connectors 42. Identically or similarly, a third conductor portion 30 may be gradually increased in a size in the y direction toward an end surface of the second wiring board 2 facing the second side surface 12s.

Each of the conductors in the first conductor portion 10 and the second conductor portion 20 has a width (size in the y direction in the drawings) which can be adjusted and designed to be made larger or smaller in accordance with a frequency of a signal flowing in the conductor for impedance adjustment.

The second conductor 122 may be in contact with or distant from the second side surface 12s in plan view. Identically or similarly, the third conductor 123 may be in contact with or distant from the second side surface 12s in plan view. If the third conductor 123 is in contact with the second side surface 12s in plan view, the second connector 42 can be shortened to reduce a possibility of an impedance change between the third conductor 123 and the third connection conductor 213 as signal conductors.

The second connection conductor 212 may be in contact with or distant from an end surface of the second wiring board 2 adjacent to the second member 12 in plan view. Identically or similarly, the third connection conductor 213 may be in contact with or distant from the end surface of the second wiring board 2 adjacent to the second member 12 in plan view. If the third connection conductor 213 is in contact with the end surface of the second wiring board 2 adjacent to the second member 12 in plan view, the second connector 42 can be shortened to reduce a possibility of an impedance change between the third conductor 123 and the third connection conductor 213 as signal conductors. If the third connection conductor 213 is distant from the end surface of the second wiring board 2 adjacent to the second member 12 in plan view, the first connection conductor 211 and the third connection conductor 213 are less likely to be connected and short-circuited even when the bonding material 21J bonding the first conductor 111 and the first connection conductor 211 expands from the second surface 21b toward the first surface 21u.

When a plurality of third conductors 123 is provided, a pair of third conductors 123 may function as differential signal lines for transmission of differential signals. In this case, the pair of third conductors 123 may be positioned to be interposed between a plurality of second conductors 122 as ground conductors. When the pair of third conductors 123 are differential signal lines, a plurality of third connection conductors 213 may be provided and a pair of third connection conductors 213 may also function as differential signal lines for transmission of differential signals.

As illustrated in FIG. 4, the first conductor portion 10 may further include a fourth conductor 124. The fourth conductor 124 does not need to be connected to the second conductor portion 20 by the first connector 41 and/or the second connector 42. The fourth conductor 124 may be positioned between the pair of third conductors 123 as signal conductors. This configuration can enhance ground potential in the first conductor portion 10. This can thus reduce a possibility of resonance in the pair of third conductors 123. The fourth conductor 124 may be in contact with or distant from the second side surface 12s in plan view. When the first conductor portion 10 includes the fourth conductor 124, the second wiring board 2 may include a conductor electrically connected to the fourth conductor 124.

As illustrated in FIGs. 2 and 6, the first upper surface 11u may include the first conductor 111 as a ground conductor and a first exposed region 110 where the first upper surface 11u is exposed. At least in plan view, the first exposed region 110 has only to be positioned to be overlapped with a position where the first connector 41 and/or the second connector 42 is connected to the second conductor portion 20 of the second wiring board 2. In this configuration, the first conductor 111 can be positioned away from and below the position where the first connector 41 and/or the second connector 42 is connected to the second conductor portion 20. This can thus reduce a possibility of an increase in capacitance component at the position where the first connector 41 and/or the second connector 42 is connected to the second conductor portion 20.

The first exposed region 110 may be in contact with or distant from the second side surface 12s. According to the embodiment illustrated in FIG. 2, the first exposed region 110 is positioned between a portion where the first conductor 111 is connected to a side surface conductor 114. According to a variation, the first exposed region 110 may have a band shape extending in the y direction. The first exposed region 110 can be determined appropriately in terms of its position, size, and shape in accordance with the position where the first connector 41 and/or the second connector 42 is connected to the second conductor portion 20.

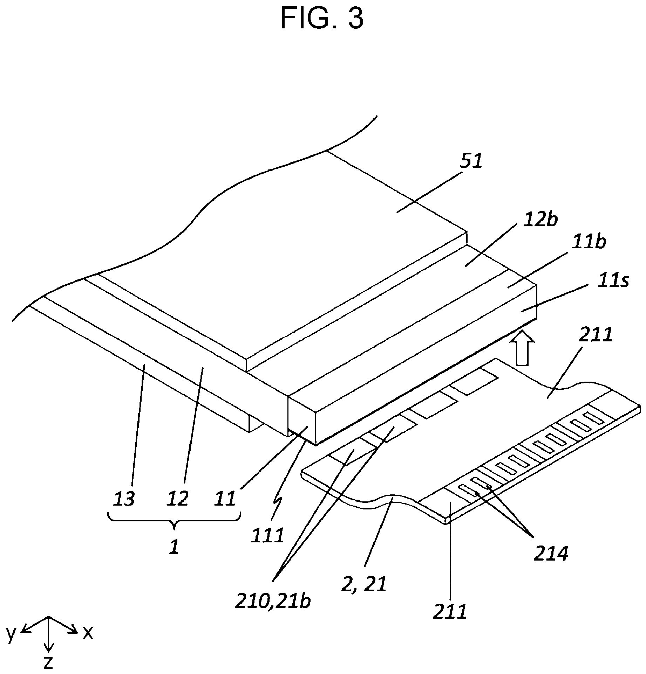

As illustrated in FIGs. 3 and 6, the second surface 21b of the second wiring board 2 may include the first connection conductor 211 as a ground conductor and a second exposed region 210 where the second surface 21b is exposed. At least in plan view, the second exposed region 210 has only to be positioned to be overlapped with the position where the first connector 41 and/or the second connector 42 is connected to the second conductor portion 20 of the second wiring board 2. In this configuration, the first connection conductor 211 can be positioned away from and below the position where the first connector 41 and/or the second connector 42 is connected to the second conductor portion 20. This can thus reduce a possibility of an increase in capacitance component at the position where the first connector 41 and/or the second connector 42 is connected to the second conductor portion 20.

The second exposed region 210 may be in contact with or distant from the end surface of the second wiring board 2. According to the embodiment illustrated in FIG. 3, the first connection conductor 211 includes the second exposed region 210 provided partially discontinuously. According to a variation, the second exposed region 210 may have a band shape extending along the end surface of the first insulating layer 21 in the y direction. The second exposed region 210 can be determined appropriately in terms of its position, size, and shape in accordance with the position where the first connector 41 and/or the second connector 42 is connected to the second conductor portion 20.

In plan view, the first exposed region 110 and the second exposed region 210 may be at least partially overlapped with each other. In this configuration, the first connection conductor 211 can be positioned further away from and below the position where the first connector 41 and/or the second connector 42 is connected to the second conductor portion 20 in comparison to a case where the first exposed region 110 and the second exposed region 210 are not overlapped with each other. This can thus more efficiently reduce a possibility of an increase in capacitance component at the position where the first connector 41 and/or the second connector 42 is connected to the second conductor portion 20.

As illustrated in FIGs. 1, 2, and 4, the second member 12 may include a recess 120 positioned at least in the second upper surface 12u. The recess 120 may be exemplarily positioned between a plurality of third conductors 123 and/or between the second conductor 122 and the third conductor 123. The recess 120 is filled with a dielectric material containing at least one selected from the group consisting of air, a resin material, a glass material, and the like, and is lower in dielectric constant than the second member 12. This achieves a reduction in capacitance component between the second conductor 122 and the third conductor 123 and/or between the plurality of third conductors 123. This enables adjustment of characteristic impedance upon transmission of a radio-frequency signal to a desired value in the third conductor 123. This can reduce a loss of signal power generated in the first conductor portion 10.

The first connection conductor 211 and the second connection conductor 212 may be electrically connected to each other in the second wiring board 2. More specifically, as illustrated in FIG. 5, the first connection conductor 211 and the second connection conductor 212 may be connected to each other by a via conductor 21V. For example, ground potential can be enhanced when the first connection conductor 211 and the second connection conductor 212 are ground conductors. When the first connection conductor 211 and the second connection conductor 212 are signal conductors, signals flowing in the first connection conductor 211 and the second connection conductor 212 can be merged to achieve signal amplification. When the first connection conductor 211 and the second connection conductor 212 are power source conductors, large drive current can flow.

As illustrated in FIG. 5, the via conductor 21V connecting the first connection conductor 211 and the second connection conductor 212 may be a so-called blind via hole. That is, the via conductor 21V connecting the first connection conductor 211 and the second connection conductor 212 does not need to be a through-hole via. This configuration can reduce a possibility that the bonding material 21J flows toward the first surface 21u and is short-circuited with the third connection conductor 213. The first connector 41 is bonded to a surface of the second connection conductor 212. This configuration can reduce a possibility that the bonding material 21J decreases flatness of the surface of the second connection conductor 212 when the first connector 41 is bonded to the second connection conductor 212. The via conductor 21V does not need to be provided entirely as a blind via hole in the second wiring board 2, and may be provided as a blind via hole exemplarily only at a position where the second wiring board 2 and the first wiring board 1 are overlapped with each other.

The first upper surface 11u and the second upper surface 12u may be flush with each other. This configuration can reduce a height (size in the z direction) of the first wiring board 1. When the first upper surface 11u and the second upper surface 12u are different in height, the first upper surface 11u and the second upper surface 12u do not need to be completely parallel to each other. For example, the first upper surface 11u may be inclined in a positive direction on an x axis, may be inclined in the positive direction or a negative direction on the x axis, or may be inclined in a positive direction or a negative direction on a y axis.

As illustrated in FIGs. 2 and 6, the second member 12 may include the second side surface 12s crossing the first upper surface 11u and the second upper surface 12u. Furthermore, the first upper surface 11u may be positioned lower than the second upper surface 12u. In this configuration, the first conductor portion 10 and the second conductor portion 20 can be made close to each other in height when the second wiring board 2 is positioned on the first upper surface 11u. The first connector 41 and/or the second connector 42 can thus be made as short as possible. This can therefore reduce a possibility of a change in impedance value in a portion where the first wiring board 1 and the second wiring board 2 are electrically connected to each other. This can also facilitate positioning of the second wiring board 2 on the first upper surface 11u.

The second wiring board 2 may be in contact with the second side surface 12s. This can further facilitate positioning of the second wiring board 2 on the first upper surface 11u. This can also reduce a possibility that the second wiring board 2 is displaced from a predetermined position on the first upper surface 11u. The second wiring board 2 does not need to be in contact with the second side surface 12s. The second wiring board 2 not in contact with the second side surface 12s is less likely to be damaged due to contact with the second side surface 12s.

As illustrated in FIG. 6, in sectional view perpendicular to the first upper surface 11u, a distance L1 from the first upper surface 11u to the second upper surface 12u may be equal to or more than a distance L2 from the first upper surface 11u of the first wiring board 1 to the first surface 21u of the second wiring board 2. When the distance L1 from the first upper surface 11u to the second upper surface 12u is equal to the distance L2 from the first upper surface 11u of the first wiring board 1 to the first surface 21u of the second wiring board 2, the second connector 42 can be made as short as possible by adjusting thicknesses of the third conductor 123 and the third connection conductor 213. This can thus reduce a possibility of a change in impedance value in a portion where the first wiring board 1 and the second wiring board 2 are electrically connected to each other.

When the second member 12 includes the second side surface 12s crossing the first upper surface 11u and the second upper surface 12u and the first upper surface 11u is positioned lower than the second upper surface 12u, the first conductor portion 10 may include the side surface conductor 114 connecting the first conductor 111 and the second conductor 122 as illustrated in FIG. 2. The side surface conductor 114 is positioned on the second side surface 12s. This configuration can enhance ground potential when the first conductor 111 and the second conductor 122 are ground conductors.

As illustrated in FIG. 2, the side surface conductor 114 may be smaller in size in the y direction than the second conductor 122.

When the first member 11 and the second member 12 are formed integrally with each other, the first conductor 111 may extend to be positioned in the second conductor 122. In this case, the first conductor 111 and the second conductor 122 may be electrically connected to each other by a via hole provided in the second member 12.

The first connector 41 may be a wire or a ribbon wire. The first connector 41 connecting the second conductor 122 and the second connection conductor 212 is not limited to one in the number, and two or a plurality of first connectors 41 may be provided as illustrated in FIG. 4. The second connector 42 may also be a wire or a ribbon wire, and a plurality of second connectors 42 may be provided as illustrated in FIG. 4. In an embodiment, an electrical connection state between the first wiring board 1 and the second wiring board 2 by the first connector 41 and/or the second connector 42 can also be called wire bonding or ribbon bonding.

As illustrated in FIG. 4, the first connectors 41 connecting two second conductors 122 positioned to interpose a pair of third conductors 123 and two second connection conductors 212 positioned to interpose a pair of third connection conductors 213 may have a gradually increased interval toward the second wiring board 2 (that is, in the positive direction on the x axis in the figure).

When the pair of third conductors 123 and the pair of third connection conductors 213 are connected by the second connectors 42, the second connectors 42 may have a gradually increased interval toward the second wiring board 2 (that is, in the positive direction on the x axis in the figure). This configuration can reduce a possibility of a rapid impedance change upon signal transmission between the pair of third conductors 123 and the pair of third connection conductors 213, and can reduce a possibility of reflection of any unnecessary electrical signal on the pair of third conductors 123 and the pair of third connection conductors 213.

The first connector 41 may be covered with an insulating material. The second connector 42 may also be covered with an insulating material. This configuration can protect the first connector 41 and/or the second connector 42 against any external impact, to reduce a possibility that the first connector 41 and/or the second connector 42 falls off to cut electrical connection between the first wiring board 1 and the second wiring board 2.

As illustrated in FIG. 1, the wiring structural body may further include the third wiring board 3 electrically connected to the second wiring board 2. The third wiring board 3 may be a printed substrate provided with an electronic circuit. More specifically, the third conductor portion 30 positioned on the third wiring board 3 has only to be electrically connected to the second conductor portion 20 of the second wiring board 2.

The second wiring board 2 may further include a fourth connection conductor 214 positioned on the second surface 21b at a position where the second wiring board 2 and the third wiring board 3 are overlapped with each other. The fourth connection conductor 214 may be electrically connected to the third connection conductor 213, and both the fourth connection conductor 214 and the third connection conductor 213 may be signal conductors.

The third connection conductor 213 and the fourth connection conductor 214 may be electrically connected to each other by a via hole positioned in the second wiring board 2. In this case, the third connection conductor 213 and the fourth connection conductor 214 do not need to be connected to each other by a blind via hole.

Electrical connection between the second wiring board 2 and the third wiring board 3 may include not only bonding between the fourth connection conductor 214 and the third conductor portion 30 but also wire connection similarly to electrical connection between the second wiring board 2 and the first wiring board 1. Furthermore, a connector such as a wire between the second wiring board 2 and the third wiring board 3 may be covered with an insulating material.

As illustrated in FIG. 1, the wiring structural body may further include a box 5 accommodating an electronic component 6. In this case, the first wiring board 1 may be part of the box 5, and the first member 11 and the second member 12 may be at least partially exposed from the box 5.

The box 5 may include a plate 51 positioned at least on the second lower surface 12b of the second member 12, and a frame 52 bonded to the plate 51 and/or the first wiring board 1. The plate 51, the frame 52, and the first wiring board 1 form a space that can accommodate the electronic component 6 to be described later.

The plate 51 is made of a material, examples of which include metallic materials such as copper, iron, tungsten, molybdenum, nickel, and cobalt, and an alloy containing any of these metallic materials. In this case, the plate 51 may be constituted by a single metal plate or a stacked body including a plurality of stacked metal plates. When the plate 51 is made of any one of the above metallic materials, the plate 51 may be provided on its surface with a plating layer of nickel, gold, or the like in accordance with an electroplating method or an electroless plating method for suppression of oxidation corrosion. The state where the plate 51 is made of a metallic material herein may mean a state where the plate 51 is substantially made of the metallic material, and may exemplarily include a state where the plate 51 contains a nonmetallic material unavoidable for production. The examples of the material for the plate 51 may include a high heat dissipator made of a carbon material such as graphite.

The frame 52 may be made of a material identical to or different from the materials for the plate 51 and/or the second member 12. The frame 52 may include a light-transmissive portion 520 penetrating the box 5 from inside to outside. The light-transmissive portion 520 serves as a window for transmission and reception of light between inside and outside the box 5.

The first wiring board 1 may further include a third member 13 positioned on the second member 12. The second member 12 and the third member 13 may be formed integrally with each other and may be made of an insulating material. In this case, the second member 12 and the third member 13 are preferably made of a ceramic material.

### <Variations>

The first member 11 includes the first lower surface 11b provided opposite to the first upper surface 11u. The second member 12 includes the second lower surface 12b provided opposite to the second upper surface 12u. The first lower surface 11b and the second lower surface 12b are flush with each other according to the embodiment illustrated in FIG. 3. For example, the second lower surface 12b may alternatively project in a negative direction on a z axis from the first lower surface 11b. The first lower surface 11b and the second lower surface 12b may also be provided with a conductor identically or similarly to the first conductor portion 10 provided on the first upper surface 11u and the second upper surface 12u. In this case, a fourth wiring board 70 provided as a wiring board different from the second wiring board 2 may be attached to the conductor provided on the first lower surface 11b and the second lower surface 12b. In this case, electrical connection between the first wiring board 1 and the fourth wiring board 70 may include connection by a third connector 72. Examples of the third connector can include a wire.

The fourth wiring board 70 may have flexibility, and may be exemplarily a so-called flexible wiring board (FPC) or a printed substrate (PCB) provided with an electronic circuit.

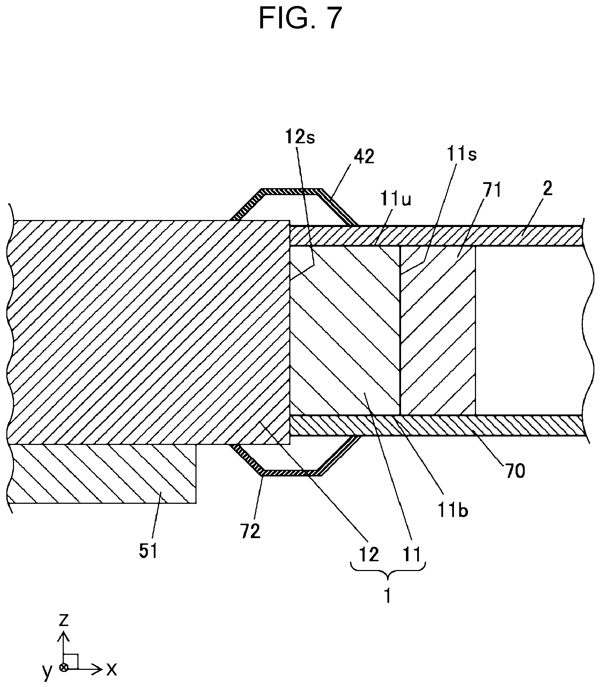

As illustrated in FIG. 7, the fourth wiring board 70 may be additionally connected to the first lower surface 11b of the first member 11. The wiring structural body can handle more electrical signals in this configuration. In this case, electrical connection between the first wiring board 1 and the fourth wiring board 70 may include connection by the third connector 72.

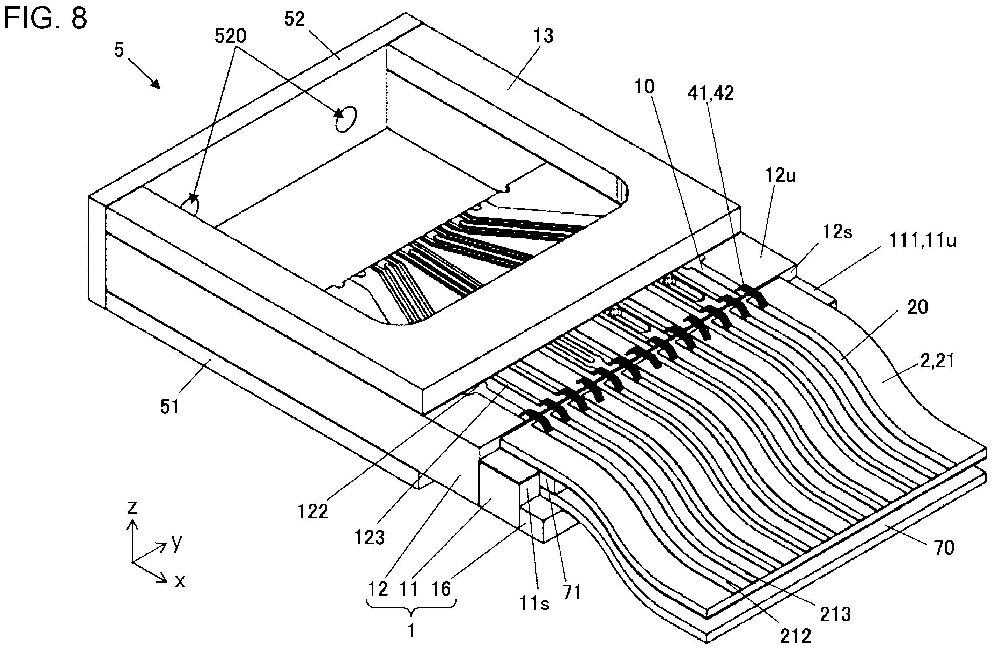

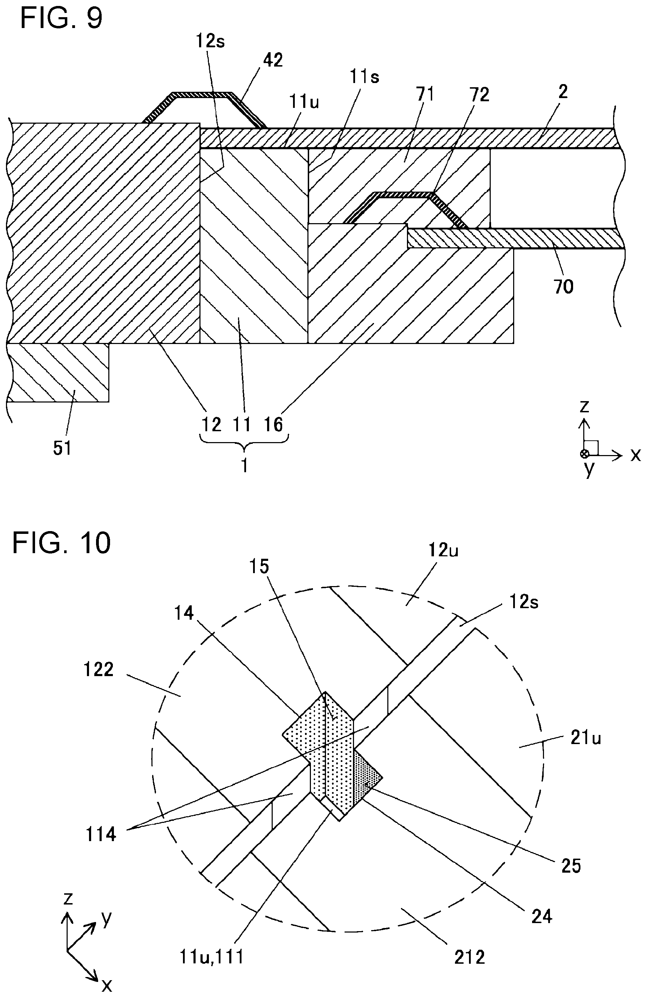

As illustrated in FIGs. 8 and 9, the first wiring board 1 may further include a protrusion 16 projecting in the positive direction on the x axis from the first side surface 11s. The fourth wiring board 70 may be additionally connected onto the protrusion 16.

As illustrated in FIG. 9, the protrusion 16 may have a stepped shape. When the fourth wiring board 70 is positioned on the protrusion 16 as illustrated in FIG. 9, the fourth wiring board 70 may be electrically connected to a conductor positioned on the protrusion 16 by the third connector 72.

As illustrated in FIGs. 7 to 9, the second wiring board 2 and the fourth wiring board 70 may be bonded to each other via the first side surface 11s by an insulating adhesive 71 made of a resin or the like. This improves bonding strength between each of the first wiring board 1 and the second wiring board 2 to the fourth wiring board 70. As illustrated in FIG. 9, the adhesive 71 may cover a third bonding member.

When the first upper surface 11u is positioned lower than the second upper surface 12u, the first wiring board 1 may include a plurality of structures each constituted by the first upper surface 11u and the second upper surface 12u. That is, the first wiring board 1 is provided with a step from the first upper surface 11u to the second upper surface 12u as illustrated in FIG. 2, and the first wiring board 1 may include a plurality of steps thus configured.

The second wiring board 2 may be bonded to the first side surface 11s of the first wiring board 1 as illustrated in FIG. 7. The second wiring board 2 may be further bonded to the first lower surface 11b of the first wiring board 1 by an adhesive extending from the first side surface 11s to the first lower surface 11b. In this case, the second wiring board 2 may be bonded to the first lower surface 11b by the insulating adhesive 71 made of a resin or the like.

As illustrated in FIG. 10, a cutout may be provided in each of the second side surface 12s of the second member 12 in the first wiring board 1 and a surface of the second wiring board 2 facing the second side surface 12s, a conductor layer may be provided on a side surface of each of the cutouts, and the conductor layers may be bonded to each other by a bonding material such as solder. That is, when the second side surface 12s includes a first cutout 14 and a first conductor layer 15 provided in the first cutout 14 and the surface of the second wiring board 2 facing the second side surface 12s includes a second cutout 24 and a second conductor layer 25 provided in the second cutout 24, the first conductor layer 15 and the second conductor layer 25 may be bonded to each other by a bonding material.

The first cutout 14 and the first conductor layer 15 can constitute a castellation or the like, and the second cutout 24 and the second conductor layer 25 can also constitute a castellation or the like.

If the first conductor layer 15 provided in the first cutout 14 is connected to a conductor (at least one of the first conductor 111 or the second conductor 122) in the first conductor portion 10 of the first wiring board 1 and the second conductor layer 25 provided in the second cutout 24 is connected to a connection conductor (at least one of the first connection conductor 211 or the second connection conductor 212) in the second conductor portion 20 of the second wiring board 2 in this case, the conductor in the first conductor portion 10 and the connection conductor in the second conductor portion 20 can be firmly electrically connected to each other. For example, when both the conductor in the first conductor portion 10 connected to the first conductor layer 15 and the connection conductor in the second conductor portion 20 connected to the second conductor layer 25 are ground conductors, ground potential can be made firm by connecting the ground conductors via the first conductor layer 15 and the second conductor layer 25.

The first cutout 14 provided in the second side surface 12s and the second cutout 24 provided in the surface of the second wiring board 2 facing the second side surface 12s may be identical in the number that may be any appropriate number equal to or more than one.

FIG. 10 exemplarily illustrates a case where the first conductor layer 15 is connected to the second conductor 122 and the second conductor layer 25 is connected to the second connection conductor 212, and does not illustrate the first connector 41. Connection between the conductor in the first conductor portion 10 of the first wiring board 1 and the first conductor layer 15 and connection between the connection conductor in the second conductor portion 20 of the second wiring board 2 and the second conductor layer 25 are not limited to exemplification in FIG. 10. As described above, the first conductor layer 15 may be connected to the first conductor 111, and the second conductor layer 25 may be connected to the first connection conductor 211.

### <Simulation results>

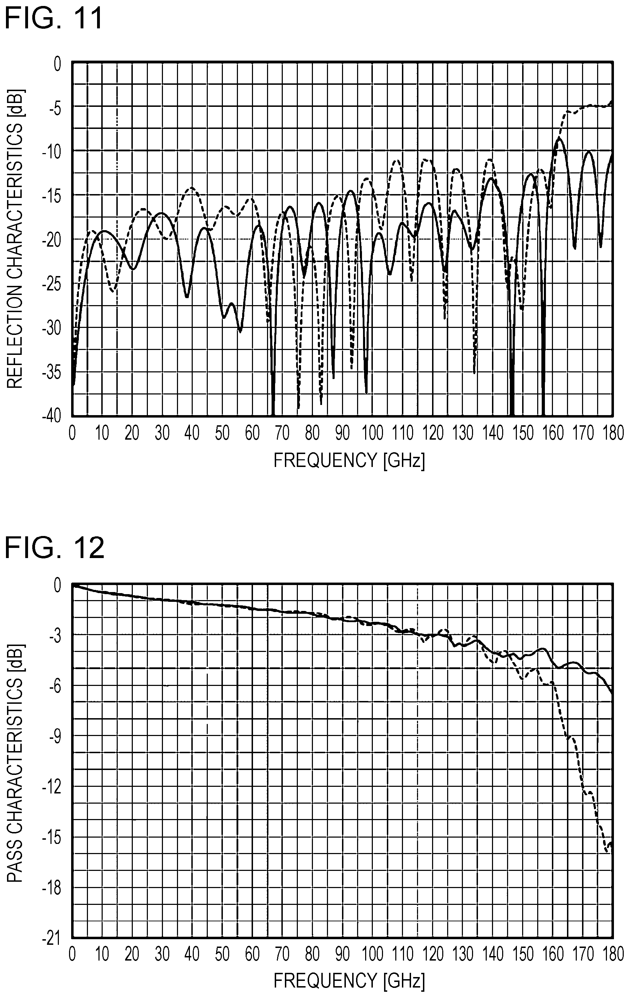

FIG. 11 is a graph indicating reflection characteristics of the wiring structural body illustrated in FIGs. 1 to 6. The graph includes a transverse axis indicating a frequency (GHz) of an input signal and an ordinate axis indicating reflection characteristics (dB). Furthermore, the graph indicating the reflection characteristics means that a signal has less reflection as the reflection characteristics (dB) have a smaller value. A solid line indicates characteristics of a wiring structural body according to an embodiment of the present disclosure. Meanwhile, a broken line indicates characteristics of a wiring structural body according to a comparative example. According to the comparative example, the wiring structural body is obtained by removing the first member 11 and the first connector 41 from the wiring structural body according to the present disclosure, and bonding the second wiring board 2 to the second conductor 122 and the third conductor 123. FIG. 11 indicates that the wiring structural body according to the present disclosure achieves more preferred reflection characteristics than the wiring structural body according to the comparative example.

FIG. 12 is a graph indicating pass characteristics of the wiring structural body illustrated in FIGs. 1 to 6. The graph includes a transverse axis indicating a frequency (GHz) of an input signal and an ordinate axis indicating pass characteristics (dB). Furthermore, the graph indicating the pass characteristics means that a signal has a smaller loss as the pass characteristics (dB) have a larger value. A solid line indicates characteristics of the wiring structural body according to an embodiment of the present disclosure. Meanwhile, a broken line indicates characteristics of the wiring structural body according to the comparative example. FIG. 12 indicates that the wiring structural body according to the present disclosure achieves more preferred pass characteristics than the wiring structural body according to the comparative example.

### <Configuration of electronic module>

In an embodiment, an electronic module may include the wiring structural body, and the electronic component 6 electrically connected to the first conductor portion 10. The electronic component 6 is not necessarily covered with a lid to be described later.

In an embodiment, the electronic module may include the wiring structural body, the electronic component 6 accommodated in the box 5, and a lid positioned on the box 5.

The lid is positioned on the box 5 to cover the interior of the box 5, such that the lid and the box 5 protect the electronic component 6.

Examples of the electronic component 6 include an optical semiconductor element such as a laser diode (LD) or a photodiode (PD), a semiconductor integrated circuit element such as a field effect transistor (FET), and a sensor element such as an optical sensor. The electronic component 6 can be made of a semiconductor material such as gallium arsenide or gallium nitride. The electronic module does not necessarily include the single electronic component 6, and may include a plurality of electronic components 6 or a plurality of types of electronic components 6. In this case, examples of the electronic component 6 may include an amplifier and a capacitor.

The electronic module may further include a seal ring positioned between the lid and the frame 52. The seal ring has a function to bond the lid to the frame 52.

In an embodiment, the electronic module can be utilized as an optical communication transceiver.

The embodiments and the variations may be combined variously without being limited to the embodiments exemplified above. Furthermore, combination is applicable also among the embodiments as well as among the variations.

### INDUSTRIAL APPLICABILITY

The present disclosure is applicable to a wiring structural body and an electronic module.

### REFERENCE SIGNS

1 first wiring board
10 first conductor portion
11 first member
11u first upper surface
11b first lower surface
11s first side surface
110 first exposed region
111 first conductor
114 side surface conductor
12 second member
12u second upper surface
12b second lower surface
12s second side surface
120 recess
122 second conductor
123 third conductor
124 fourth conductor
13 third member
14 first cutout
15 first conductor layer
16 protrusion
2 second wiring board
20 second conductor portion
21 first insulating layer
21u first surface
21b second surface
210 second exposed region
211 first connection conductor
212 second connection conductor
213 third connection conductor
214 fourth connection conductor
21V via conductor
21J bonding material
24 second cutout
25 second conductor layer
3 third wiring board
30 third conductor portion
41 first connector
42 second connector
5 box
51 plate
52 frame
520 light-transmissive portion
6 electronic component
70 fourth wiring board
71 adhesive
72 third connector

## Claims

1. A wiring structural body comprising:
a first wiring board including a first member, a second member provided continuously to the first member, and a first conductor portion;
a second wiring board including a first insulating layer and a second conductor portion; and
a first connector electrically connecting the first wiring board and the second wiring board; wherein
the second wiring board extends from the second member,
the first insulating layer includes a first surface and a second surface provided opposite to the first surface,
the first member includes a first upper surface and a first side surface crossing the first upper surface,
the second member includes a second upper surface, and faces or is positioned on a surface different from the first side surface of the first member,
the first conductor portion includes a first conductor positioned on the first upper surface, and a second conductor positioned on the second upper surface,
the second conductor portion includes a first connection conductor positioned on the second surface, and a second connection conductor positioned on the first surface,
at least part of the second surface faces the first upper surface and is positioned to be overlapped with the first upper surface in plan view,
the first conductor and the first connection conductor are bonded to each other, and
the first connector electrically connects the second conductor and the second connection conductor.

2. The wiring structural body according to claim 1, wherein the first conductor and the first connection conductor are ground conductors.

3. The wiring structural body according to claim 1 or 2, wherein the second conductor and the second connection conductor are signal conductors or ground conductors.

4. The wiring structural body according to any one of claims 1 to 3, the wiring structural body further comprising
a second connector electrically connecting the first wiring board and the second wiring board, wherein
the first conductor portion further includes a third conductor positioned to be spaced apart from the second conductor on the second upper surface,
the second conductor portion further includes a third connection conductor positioned to be spaced apart from the second connection conductor on the first surface,
the second connector electrically connects the third conductor and the third connection conductor,
the first conductor and the first connection conductor are ground conductors,
the second conductor and the second connection conductor are ground conductors, and
the third conductor and the third connection conductor are signal conductors.

5. The wiring structural body according to any one of claims 1 to 4, wherein the first connection conductor and the second connection conductor are electrically connected to each other in the second wiring board.

6. The wiring structural body according to any one of claims 1 to 5, wherein
the second member includes a second side surface crossing the first upper surface and the second upper surface, and
the first upper surface is positioned lower than the second upper surface.

7. The wiring structural body according to claim 6, wherein in sectional view perpendicular to the first upper surface, a distance L1 from the first upper surface to the second upper surface is equal to or more than a distance L2 from the first upper surface to the first surface.

8. The wiring structural body according to claim 6 or 7, wherein
the second wiring board is in contact with the second side surface.

9. The wiring structural body according to any one of claims 1 to 8, wherein
the second member includes a second side surface crossing the first upper surface and the second upper surface,
the second side surface includes a first cutout, and a first conductor layer provided in the first cutout,
the second wiring board includes a surface facing the second side surface and including a second cutout and a second conductor layer provided in the second cutout, and
the first conductor layer and the second conductor layer are bonded to each other by a bonding material.

10. The wiring structural body according to any one of claims 1 to 9, wherein
the second member includes a second side surface crossing the first upper surface and the second upper surface,
the first upper surface is positioned lower than the second upper surface,
the first conductor portion includes a side surface conductor electrically connecting the first conductor and the second conductor, and
the side surface conductor is positioned on the second side surface.

11. The wiring structural body according to any one of claims 1 to 10, wherein the first connector is a wire.

12. The wiring structural body according to claim 11, wherein the first connector is covered with an insulating material.

13. The wiring structural body according to any one of claims 1 to 12, wherein the second wiring board is a flexible wiring board.

14. The wiring structural body according to any one of claims 1 to 13, the wiring structural body further comprising a third wiring board electrically connected to the second wiring board.

15. The wiring structural body according to any one of claims 1 to 14, the wiring structural body further comprising
a box accommodating an electronic component, wherein
the first wiring board is part of the box, and
the first member and the second member are at least partially exposed from the box.

16. An electronic module comprising:
the wiring structural body according to any one of claims 1 to 14; and
an electronic component electrically connected to the first conductor portion.

17. An electronic module comprising:
the wiring structural body according to claim 15;
an electronic component accommodated in the box; and
a lid positioned on the box.
